Europäisches Patentamt

European Patent Office

Office européen des brevets

(19)

(11) Publication number: **0 061 158**
**B1**

(12) EUROPEAN PATENT SPECIFICATION

(45) Date of publication of patent specification: **09.09.87**

(51) Int. Cl.⁴: **H 01 L 27/01**

(21) Application number: **82102232.4**

(22) Date of filing: **18.03.82**

(54) Method for firing thick film electronic circuits.

(30) Priority: **23.03.81 US 246235**
**28.09.81 US 306200**

(43) Date of publication of application:
**29.09.82 Bulletin 82/39**

(45) Publication of the grant of the patent:
**09.09.87 Bulletin 87/37**

(84) Designated Contracting States:
**AT BE CH DE FR GB IT LI LU NL SE**

(56) References cited:
**US-A-3 415 503**

**SOLID STATE TECHNOLOGY, vol. 24, no. 6,
June 1981, pages 39-43, Port Washington
(USA); J.L.RESUTEK et al.: "Infrared firing of
thick film compositions"**

(73) Proprietor: **RADIANT TECHNOLOGY
CORPORATION**
**13856 Bettencourt Street**
**Cerritos California 90701 (US)**

(72) Inventor: **Crain, Norman Robert**
**9432 Daytona Circle**
**Huntington Beach California 92646 (US)**
Inventor: **Hardison, Robert Perry c/o Radiant
Techn. Corp.**
**13856 Bettencourt Street**
**Cerritos California 90701 (US)**
Inventor: **Richert, Carson Thomas**
**5618 Cajon Avenue**
**Buena Park California 90620 (US)**

(74) Representative: **Patentanwälte Grünecker, Dr.
Kinkeldey, Dr. Stockmair, Dr. Schumann, Jakob,
Dr. Bezold, Meister, Hilgers, Dr. Meyer-Plath**
**Maximilianstrasse 58**
**D-8000 München 22 (DE)**

Courier Press, Leamington Spa, England.

## Description

This invention relates to an infrared furnace for firing thick film circuits comprising a heating chamber having isulated wall defining an elongated straight tunnel disposed on a longitudinal axis between an entrance and an exit, a product conveyor movable through the tunnel along the longitudinal axis between the entrance and the exit, a plurality of elongated tubular infrared lamps disposed in the tunnel in direct communication with the conveyor and means for applying electrical energy to the lamps to energize them.

A thick film electronic circuit comprises a relatively thick, insulative substrate on which relatively thin layers of material are deposited to form resistors, capacitors, conductors, and the like. Typically, the substrate is made from 96% Alumina and the layers are made from gold, silver, glass, a mixture of Ruthenium oxide and glass frit particles and various dielectric materials applied to the substrate in paste form by silk screening techniques. After applying the paste to the substrate, the thick film circuit is fired in a furnace to cure and/or dry the layers on the substrate.

To cure thick film circuits, they are conventionally transported on a conveyor through a furnace maintained at a temperature of approximately 850° to 900°C (US—A—3 415 503). In the furnace, a heating element is disposed around the heating zone through which the thick film circuits are transported. Insulation surrounds the heating element to reduce heat transfer away from the heating zone. A muffle disposed between the heating element and the heating zone protects the heating element and seals the heating zone between its ends to permit control of the atmosphere in the heating zone. In the described furnace, the heating element heats the entire furnace, including insulation and muffle, to an operating temperature in the range of 850° to 900°C. Heat is transferred to the thick film circuits being transported through the furnace by indirect radiation from the walls of the muffle and by convection. In the firing process, the thick film circuits are heated to a temperature approaching the operating temperature in the furnace. Because of the small temperature differential between the operating temperature and the thick film circuits, the temperature of the thick film circuits rises asymptotically and thus slowly to its maximum value. As a result, great care must be taken to control the operating temperature so as to do no damage to the layers on the substrate, particularly the Ruthenium oxide resistors.

In Solid State Technology, Volume 24, No. 6, June 1981, pages 39—43, Port Washington, USA an infrared furnace of the kind described in the prior art portion of claim 1. This document also describes a method for firing thick film circuits, which thick film circuits are transported through a heating chamber and are radiated therein with infrared energy throughout a heating zone defined by heat-insulative walls. Furthermore, the infrared energy may be concentrated in the near infrared band.

The object to be solved by the invention is to provide an infrared furnace of the kind described in the beginning, which infrared furnace allows an automatic control of the temperature in the furnace.

Accordingly the infrared furnace is characterized in that temperature probes are provided for sensing the temperature in at least one zone of the tunnel and means responsive to the temperature sensing probes are provided for controlling the voltage of the electrical energy applied to the infrared lamps to maintain the desired operating temperature in the zone constant, and to maintain the quantity of heat that needs to be transferred to the thick film circuits which in turn depends upon the transport speed of the thick film circuits.

Advantageous embodiments are claimed by the subclaims.

Brief Description of the Drawings
The features of a specific embodiment of the best mode contemplated of carrying out the invention are illustrated in the drawings in which:

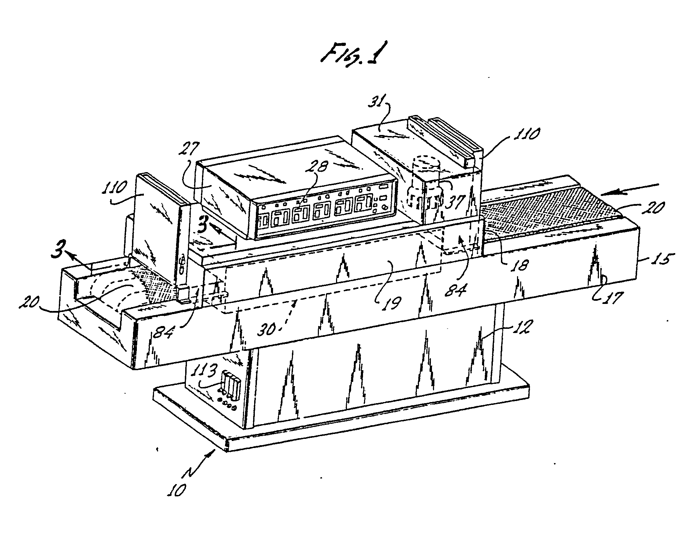

Fig. 1 is an overall front perspective view of an infrared furnace for practicing the present invention;

Fig. 2 is a front view of the infrared furnace shown in Fig. 1 with the front panels removed to show the heating chamber therein;

Fig. 3 is a sectional view of the baffle unit on the entrance end portion of the heating chamber as taken on line 3—3 of Fig. 1;

Fig. 4 is a transverse sectional view of the heating chamber as taken on line 4—4 of Fig. 3;

Fig. 5 is an enlarged transverse sectional view showing a portion of the heating chamber with the front panels mounted on the supporting framework therefor;

Fig. 6 is an overal perspective view of the heating chamber;

Fig. 7 is a perspective view of the baffle unit on the entrance end of the heating chamber;

Fig. 8 is an enlarged cross-sectional view showing the end portion of an infrared lamp mounted in the ceramic holder secured in the sidewall of the heating chamber;

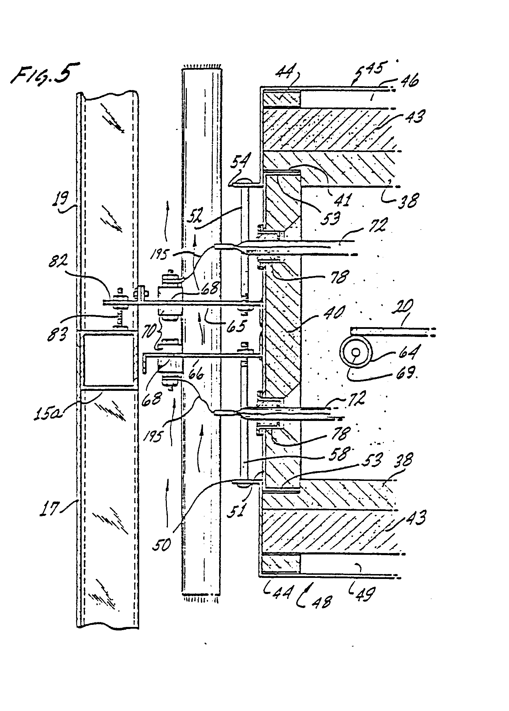

Fig. 9 is a perspective view showing the end portions of an infrared lamp mounted in the ceramic holders securd on each of the sidewalls of the heating chamber;

Fig. 10 shows the metal terminal on the right end portion of an infrared lamp being moved through the ceramic holder secured on the right sidewall of the heating chamber;

Fig. 11 shows the metal terminal on the right end portion of the infrared lamp being moved out of the ceramic holder secured on the left sidewall of the heating chamber;

Fig. 12 is an enlarged cross-sectional view showing the end portion of an infrared lamp mounted in an alternate embodiment of the ceramic holder secured in the sidewall of the heating chamber;

Fig. 13 is an end view of the ceramic holder taken along the line 13—13 of Fig. 12;

Fig. 14 is a diagram showing the power spectrum of an infrared radiation source of the type utilized in practicing the invention;

Fig. 15 is a graph comparing the processing time in an IR furnace as utilized in practicing the invention with a conventional furnace;

Fig. 16 is a graph comparing the startup time of an IR furnace as utilized in practicing the invention with a conventional furnace;

Fig. 17 is a graph comparing the temperature profile change time of an IR furnace as utilized in practicing the invention with a conventional furnace;

Fig. 18 is a graph comparing relative power usage of an IR furnace as utilized in practicing the invention with a conventional furnace;

Fig. 19 is a graph depicting the differences in near infrared absorption of different thick film materials as a function of wavelength;

Fig. 20 is an enlarged side-sectional view of a portion of a thick film circuit processed in an IR furnace as utilized in practicing the invention; and

Fig. 21 is a schematic block diagram of the apparatus for controlling the operating temperature in the described IR furnace.

Detailed Description of the Specific Embodiments

Referring to Fig. 2 of the drawings, the infrared furnace 10 of the present invention includes a pedestal 12 having mounted thereon a rectangular lower framework 15. The enclosure for the lower framework is provided with a removable front panel 17. Mounted on the top of the rectangular framework 15 inwardly from the ends thereof is a shorter, rectangular upper framework 18. The enclosure for the upper framework 18 is provided with a removable front panel 19. A heating chamber 30 is supported within the lower and upper frameworks 15 and 18. Mounted on the top of the upper framework 18 is a compartment 27 having on the front thereof a panel 28 which provides electronic controls for controlling the temperature in different zones along the length of the heating chamber 30. Mounted in a compartment 31 on the side of the compartment 27 is an electric fan 37 for drawing cooling air entering an opening (not shown) in the back of the pedestal 12 past the electronic power circuits enclosed therein and up past the sides of the heating chamber 30.

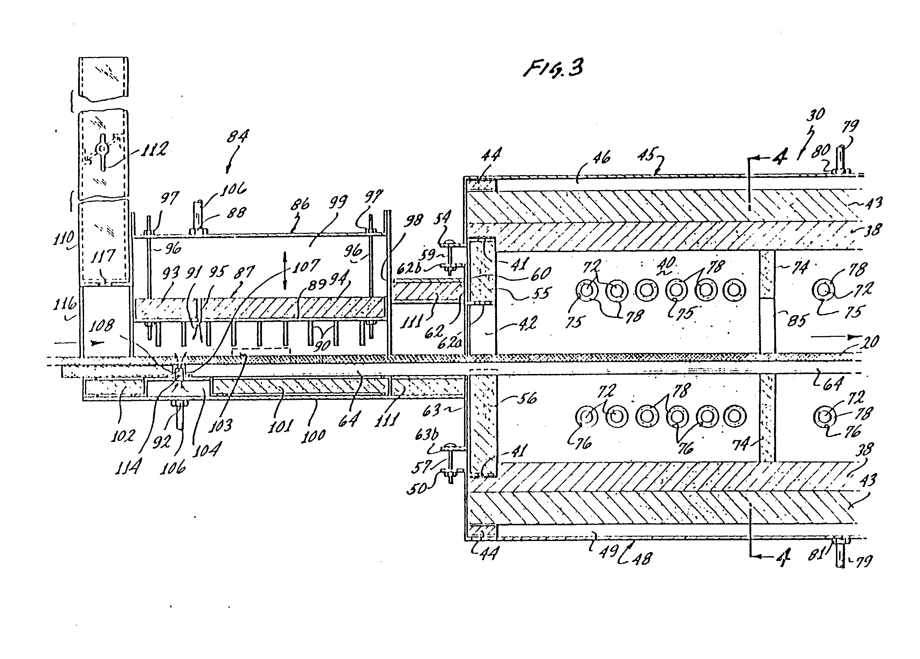

Reference will next be made to Fig. 2 which shows a front view of the infrared furnace 10 with the front panels 17 and 19 removed from the respective lower and upper frameworks 15 and 18. As shown, the elongated rectangularly shaped heating chamber 30 is supported as a unit at its four corners by support lugs 82 attached by bolts 83 to the upper longitudinal side members 15a of the lower framework 15 (Fig. 5). Mounted on the end of the lower framework 15 adjacent the entrance end of the heating chamber 30 is a drive roller 16 and mounted on the other end of the lower framework adjacent the exit end of the heating chamber 30 is a smaller roller 21. An endless conveyor belt 20 engages about the peripheral surfaces of the rollers 16 and 21. An adjustable roller 24 associated with the drive roller 16 provides for controlling the tension on the upper portion of the conveyor belt 20 spanning the rollers 16 and 21. The drive roller 16 is provided with a gear 22 on its hub which is attached by a chain drive 23 to a lower gear 25 supported on the lower framework 15. An electric motor 26 has its shaft coupled to drive the lower gear 25.

It is thus seen that the endless conveyor belt 20, which is of the open-mesh type and preferably formed of stainless steel, horizontally passes through the heating chamber 30 which is mounted between the spaced top longitudinal side members 15a of the lower framework 15.

Reference will next be made to an overall perspective view of the heating chamber 30 as illustrated in Fig. 6 and a cross-sectional view thereof as illustrated in Fig. 4. The heating chamber 30 is an elongated rectangularly shaped enclosure having its upper and lower walls constructed of sheets 38 of insulation, and having its side walls constructed of sheets 40 of insulation. The sheets 38 and 40 of insulation are formed by compressing a heat insulating material such as a white alumina fiber so that it forms a porous structural wall having a relatively smooth surface. The alumina fiber of which the sheets 38 and 40 are formed has a 1648.9°C (3000°F rating. To facilitate the interfitting of the side sheets 40, the inner side edges of the upper and lower sheets 38 are provided with right angled notches 41. Provided on the upper and lower walls of the heating chamber formed by the sheets 38 of insulation are outer sheets 43 of insulation. These outer sheets 43 of insulation are similarly formed of a compressed heat-insulating material such as an alumina fiber which is characterized by being porous and has a 1093.3°C (2000°F) rating. Strips 44 of similar insulation are secured along the four edges of the top and bottom outer sheets 43 of insulation. Additionally, several longitudinally extending short strips 47 of similar insulation material are secured in spaced relationship on the top and bottom outer sheets 43.

A sheet metal side wall 51 covers each of the side sheets 40 of insulation and is provided with flanges 53 on the top and bottom thereof which fit in the right angled notches 41 provided on the inner side edges of the upper and lower sheets 38 of insulation.

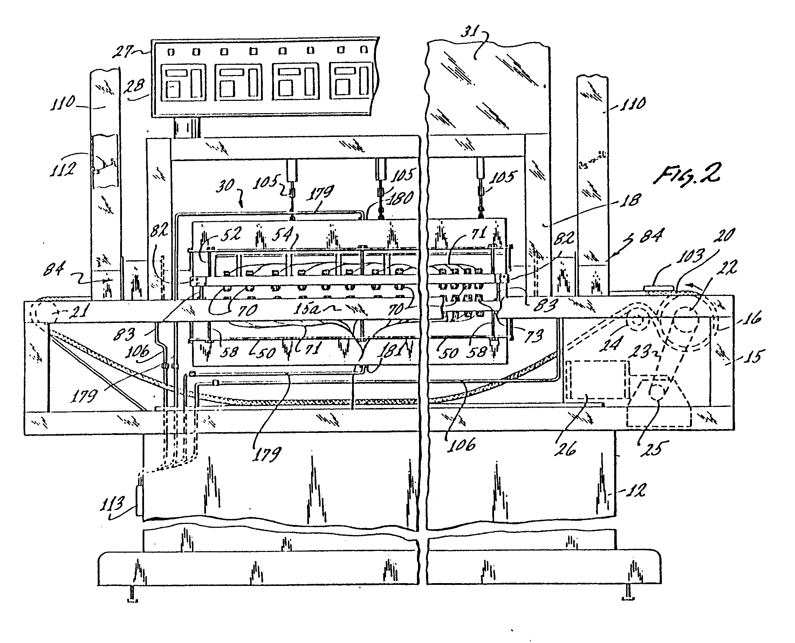

As shown in Fig. 4, which is a transverse section through the heating chamber as taken along line 4—4 of Fig. 3, upper and lower horizontally disposed metal tray members 65 and 66 are provided on each side of the heating chamber 30. Each tray member extends the full length of the heating chamber 30 and is spot welded to the sheet metal side walls 51 thereof.

As best illustrated in Fig. 6, the end wall at each end of the heating chamber 30 comprises an upper insulation sheet member 55 and a lower insulation sheet member 56 which are vertically spaced to provide a rectangular port or opening 42 through which the conveyor belt 20 passes. The lower insulation member 55 is provided on the upper edge thereof with three spaced semi-circular grooves 39. A sheet metal end wall 60 having a rectangular opening therein conforming with the opening 42 covers the two insulation members 55 and 56. A sheet metal upper bracket 62 provided with an outer flange 62b on the top thereof and an inner flange 62a on the bottom thereof is positioned with its inner flanges 62a engaging the top edge of the opening 42. Likewise, a sheet metal lower bracket 63 provided with an outer flange 63b on the bottom thereof with cutouts corresponding to grooves 39 and an inner flange 63a on the top thereof is positioned with its inner flange 63a engaging the bottom edge of the opening 42.

A sheet metal top casing or cover 45 provided with flanges 54 is fitted down over the upper end portion of heating chamber 30 with its top inner wall contacting the edge strips 44 of insulation thereby forming an upper plenum chamber 46. Likewise, a sheet metal bottom casing or cover 48 provided with flanges 50 is fitted up over the lower end portion of the heating chamber 30 with its bottom inner wall contacting the edge strips 44 of insulation thereby forming a lower plenum chamber 49.

As shown in Fig. 4, to hold the insulating walls of the heating chamber 30 in assembled position, the sides of the top cover 45 of the heating chamber are drawn down over the side walls 51 and held by tie rods 52 passing through openings in the side flanges 54 of the top cover 45 and aligned openings in the walls of the upper metal tray member 65. Likewise, the sides of the bottom cover 48 of the heating chamber 30 are drawn up over the side walls 51 and held by tie rods 58 passing through openings in the side flanges 50 of the bottom cover 48 and aligned openings in the walls of the lower metal tray members 66. The ends of the top cover 45 are drawn down and held by tie rods 59 (Fig. 3) passing through openings on the end flanges 54 on the top cover 45 and aligned openings on the flanges 62b on upper brackets 62. Likewise, the ends of the bottom cover 48 are drawn up and held by tie rods 57 passing through openings on the end flanges 50 on the bottom cover 48 and aligned openings on the flanges 63b on lower brackets 63.

The endless conveyor belt 20 is supported to ride within the heating chamber 30 on three quartz tubes 64 which extend throughout the length of the heating chamber 30 and rest on the three semi-circular grooves 39 provided on the lower insulation members 56 of the end walls.

Each of the sidewalls of the heating chamber is provided with an upper series of spaced circular holes 75 above the conveyor belt 20 and a lower series of spaced circular holes 76 below the conveyor belt 20. Each of the circular holes 75 and 76 extends through the sheet metal side covers 51 and the sheet 40 of insulation forming each of the sidewalls. The inner half portions of each of the holes 75 and 76 in the sheet 40 of insulation is provided with a forty-five degree chamfer 177.

A mounting device in the form of a ceramic holder 184 is positioned in each of the circular holes 75 and 76. Each ceramic holder has a hollow cylindrical body 185 with a shoulder 187 on the outer end thereof and a bottom wall 188 on the inner end thereof. The bottom wall 188 is provided with a concentric circular opening 189 and a pair of diametrically disposed keyways or notches 190. The length of the body 185 of the ceramic holder 184 is approximately one-half the thickness of the side sheets 40 of insulation.

Each ceramic holder 184 is positioned with its cylindrical body 185 having a relatively close fit in one of the circular holes 75 or 76 on the sidewalls and with the shoulder 187 thereof lying against the sheet metal side wall 51 and permanently sealed in position by use of a silicone sealant 191.

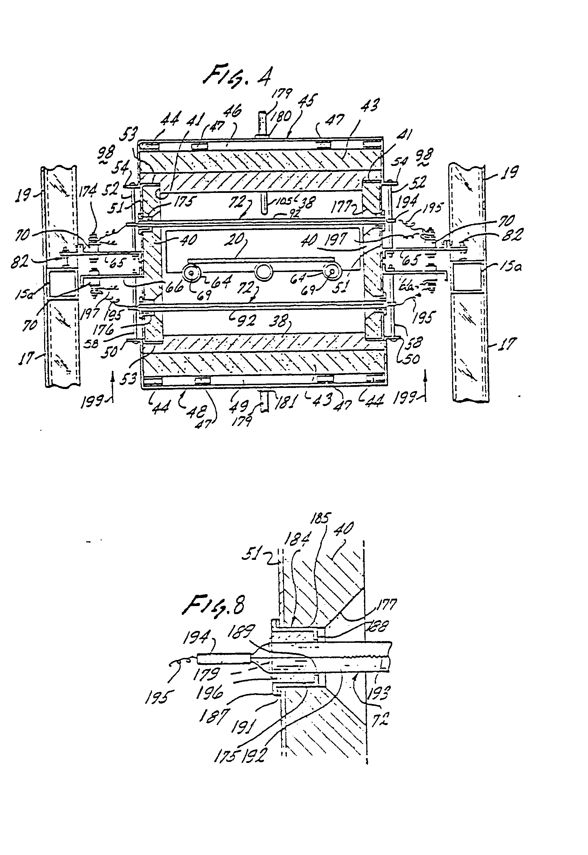

A plurality of elongated infrared lamps 72 are mounted with their end portions passing through the respective circular openings 189 in opposing ceramic holders 184 secured on the sidewalls of the heating chamber 30. Lamps 72 are thus arranged side by side transverse to the direction of movement of conveyer belt 20 above and below conveyor belt 20. Each infrared lamp 72 comprises a transparent or translucent elongated quartz tube 192 in the center of which is located an electrically heated infrared ray emitting filament 193 which is preferably made of tungsten. As specifically illustrated in Figs. 8 and 12, tube 192 is hermetically sealed at its ends. The ends of the quartz tube 192 are provided with generally rectangularly shaped flat metal terminals 194 which connect to the respective ends of the tungsten filament 193. The metal terminals are a little wider than the diameter of the quartz tube 192 of the infrared lamp 72. Leads 195 are connected to each metal terminal 194. The described infrared lamps are well known, commercially available products, the tubes thereof generally being charged with an inert gas such as Argon. Fig. 14 shows a typical power spectrum for such an infrared source. As depicted, the power is concentrated in the near infrared band extending approximately from 0.7μm to approximately 2.5μm. The exact distribution and the wavelength of the peak power vary as a function of the temperature of the lamp filament. Generally, sufficient electrical voltage is supplied to the lamp filament to maintain a filament temperature typically in the range of 1127 to 1727°C (1400° to 2000°K), depending upon the desired operating temperature and the quantity of heat that needs to be transferred to the thick film circuits, which in turn depends upon the transport speed.

To mount an infrared lamp 72 in a pair of the ceramic holders 84 provided in the upper holes 75 on the sidewalls of the heating chamber 30, the metal terminal 194 on one end of the infrared lamp 72 is inserted into the cermic holder 184 secured in hole 75 on one of the sidewalls. The infrared lamp 72 is then rotated, as needed, such that its metal terminal 194 passes through the notches 190 on the bottom wall 188 of the ceramic holder. The quartz tube 192 of the infrared lamp 72 is then pushed through the circular opening 189 in the bottom wall 188 of the ceramic holder 184 until the metal terminal 194 reaches the opposing hole 75 in the opposite sidewall. The chamfer 177 on the inner portion of the hole 75 aids in guiding the metal terminal 94 into the hole. Rotation of the infrared lamp then enables the metal terminal 194 to slide through the notches 190 in the bottom wall 188 of the ceramic holder 184 on this opposite sidewall such that the end portions of the infrared lamp 72 protrude outwardly from each of the ceramic holders 184. A gasket 196 formed of resilient refractory material, such as alumina fiber, and in the shape of a short tube, is then fitted over the metal terminal 194 on each end of the infrared lamp 72 and packed tightly within the ceramic holder 184. It may be desirable in some cases to apply a silicone sealant 179 on the outer end of the cylindrical opening of the ceramic holder 184 to provide further sealing.

It may be desirable in other cases to saturate the short tube-like alumina gasket 196 in a solution of soluble refractory material such as sodium silicate just prior to inserting it over the metal terminal 194 on the end of the infrared lamp 172 and packing it into the cavity of the ceramic holder 184 around the quartz tube 192. Upon drying, the alumina gasket 196 is effectively bonded to the wall of the ceramic holder 184 and the wall of the quartz tube 192 of the infrared lamp 72. This assures that the alumina gasket 196 does not work loose in the ceramic holder 184 as a result of the expansion and contraction of the sidewalls of the heating chamber 30 and that the joint will remain gastight.

It should now be clearly understood that an infrared lamp 72 is thus transversely disposed in each of the opposing pairs of upper and lower holes 75 and 76 in the sidewalls of heating chamber 30 with its flat metal terminals 194 protruding outside each of the sheet metal side walls 51.

As shown in Fig. 4, the upper and lower tray members 65 and 66 attached on the sidewalls of the heating chamber 30 each has a series of spaced ceramic posts 70 mounted along the length thereof corresponding to the upper and lower series of spaced holes 75 and 76 in the sidewalls of the heating chamber 30. The metal contacts 174 on the ends of the ceramic posts 70 have connected thereto the ends of the leads 195 on the metal terminals 194 of the associated infrared lamp 72. Each metal contact 174 on the ceramic post 70 is connected, in turn, by a lead 197 to the power circuits within the pedestal 12 and the control panel 28. These leads 197 are bundled together and passed through vertical tubular guides 79 held in openings on the longitudinal ends of the upper and lower metal trays 65 and 66 (Fig. 5).

A cover gas which may be nitrogen or oxygen, for example, may be fed under a low pressure by way of tubes 179 to connectors 180 and 181 on the respective top and bottom plenum chambers 46 and 49 on the heating chamber 30, as illustrated in Fig. 4 and 6. The cover gas slowly and evenly filters through the porous sheets 42 and 38 of insulation which form each of the top and bottom walls of the heating chamber 30 thus causing the interior of the heating chamber to be at a slightly higher pressure than the atmosphere surrounding the infrared furnace. It is for this reason that the ceramic holder 184 is provided with a silicone sealant 191 on its shoulder 187 to prevent cover gas in the heating chamber 30 from escaping at these points and the alumina gasket 196 is provided within each of the ceramic holders 184 to seal off the openings 189 in the bottom walls 188 thereof through which the end portions of the quartz tube 192 of the infrared lamp 72 pass.

As illustrated in Fig. 4, the upper and lower metal tray members 65 and 66 provide for holding the leads 195 and 197 spaced away from the sidewalls of the heating chamber 30. Thus, with the front and back upper and lower panels 17 and 19 in position on the respective lower and upper frameworks 15 and 18, vertical passageways 98 are formed on the longitudinal sides of the heating chamber 30 through which fan 37 can draw cooling air, as indicated by arrows 199, to cool the leads 195 and 197 and the metal terminals 194 of the infrared lamps 72.

It should be noted that, if were it not for the silicone sealant 191 on the shoulders 187 of the ceramic holders 184 and the alumina gaskets 196 on the end portions of the lamp 72, the cooling air moving past the protruding end portions of the infrared lamp 72 could possibly seep through holes 75 or 76 on the sidewalls, contaminating the atmosphere within the heating chamber.

It should be especially noted that the bottom wall 188 of the ceramic holder 184 provides for retaining the aluminal gasket 196 so that it will not be accidentally pushed into the interior of the heating chamber 30 when the infrared lamp 72 is being inserted or removed from its mounting in the sidewalls of the heating chamber 30.

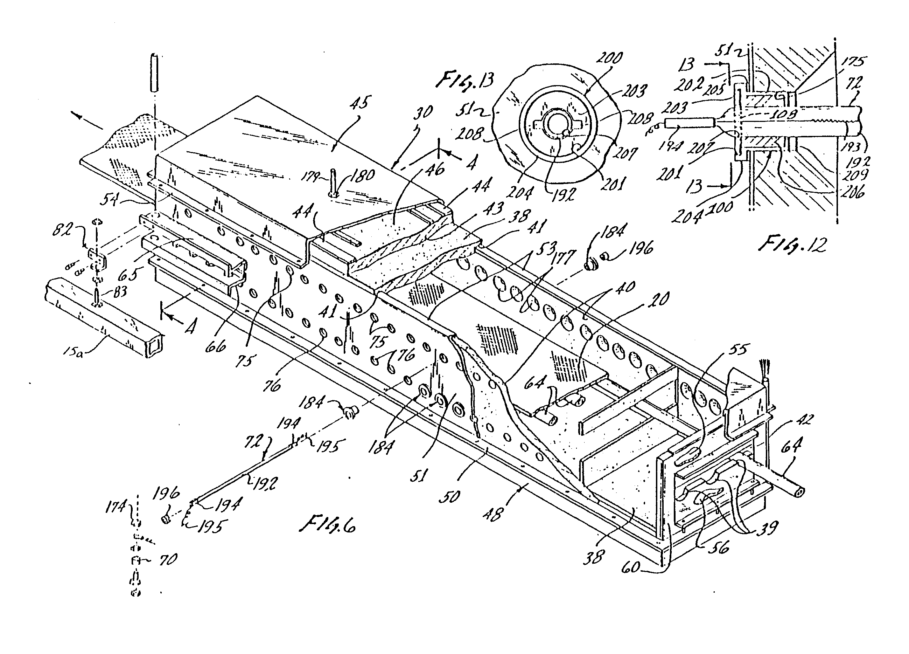

When an infrared lamp 72 burns out and is to be replaced, the leads 195 connected to the metal terminals 194 on each end thereof are disconnected from the metal contacts 174 on the ends of the ceramic posts 70 provided on the tray members 65 or 66. As illustrated in Fig. 10, the resilient alumina gaskets 196 are then removed from the ceramic holders 184 on each of the sidewalls of the heating chamber 30. The infrared lamp 72 is then rotated, as needed, by use of the protruding opposite left end thereof such that the right metal terminal 194 can slide through the notches 190 on the bottom wall 188 of the ceramic holder 184 on the right side-wall. Continued pulling of the left end of the infrared lamp 72 then causes the metal terminal 194 of the right end thereof to pass through the notches 190 of the ceramic holder 184 on the left sidewall, as illustrated in Fig. 11.

It should be now clear that each infrared lamp 72 in the heating chamber 30 is readily individually serviceable and replaceable without the disconnection of or disturbance of any of the other lamps. Furthermore, the close fit of the ceramic holders 184 in the holes 75 and 76 in the side-walls of the heating chamber 30 and the securing of the shoulders 187 thereof on the sheet metal covers 51 not only give support to the ceramic holders 184 but provide for a precise replacement of the infrared lamps 72 in the heating chamber 30. Moreover, the ceramic holders 184 serve as a barrier to protect the metal terminals 194 from the heat of the heating chamber.

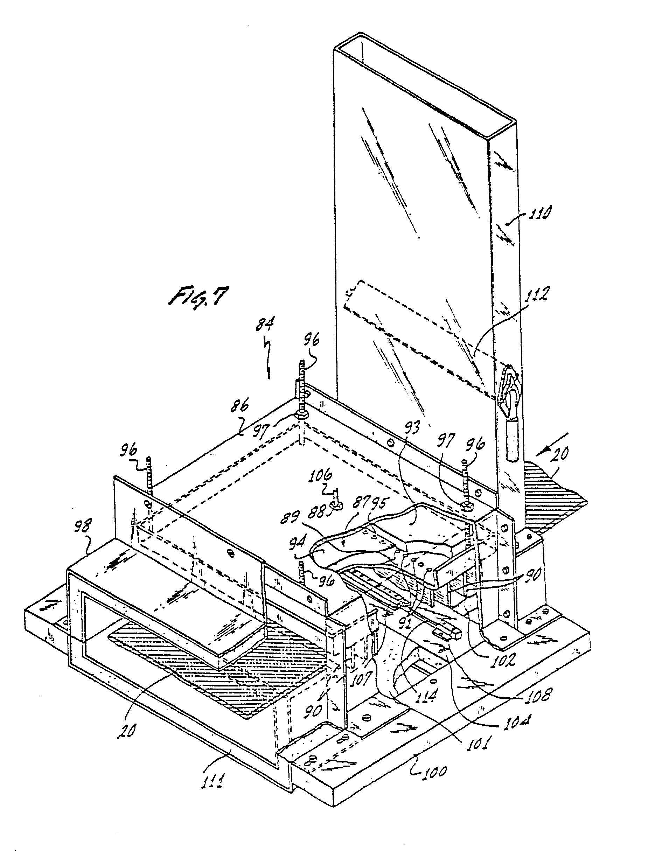

An alternate embodiment of a ceramic holder 200 is shown in Figs. 12 and 13. The ceramic holder 200 is shaped similarly to the ceramic holder 184 shown in Fig. 8 with the exception that the holder 200 is provided with an internal concentric recess 201 on the outer end of the cylindrical body 202 thereof. Each of the ceramic holders 200 is inserted in a hole 75 or 76 in the sidewall of the heating chamber 30 with its shoulder 204 cemented by a silicone sealant 205 to the sheet metal side cover 51 of the heating chamber 30. An infrared lamp 72 is then inserted such that its end portions extend through respective opposing ceramic holders 200. A gasket 206 of alumina fiber is then fitted over each of the end metal terminals 194 of the infrared lamp 72 and tightly packed into the cavity of the ceramic holder 200 around the quartz tube 192. A circular ceramic end cover 203 having a concentric opening 207 with diametrically opposing keyways or notches 208 (see Fig. 13) thereon is then positioned over the metal terminal 194 of the infrared lamp 72 with its concentric opening 207 fitted closely about the quartz tube 192 of the infrared lamp 72. The ceramic end cover 203 has its inner surface wetted with a sodium silicate solution which upon drying provides for effectively cementing the end cover 203 within the internal circular recess 201 of the ceramic holder 200. Note that the end cover 203 serves to retain the alumina gasket 206 tightly packed within the cavity of the ceramic holder 200 and, together with the bottom wall 209, prevents the gasket 206 from working loose with the contration and expansion of the sidewalls resulting from the heating and cooling of the chamber 30.

The entrance portion of the heating chamber 30 is separated from the remaining portion thereof by a vertical wall formed of upper and lower sheet members 74 (Fig. 13) of high temperature insulation spaced to provide a central rectangular opening 85 for the traveling endless conveyor belt 20. As shown in Fig. 6, the series of upper and lower holes 75 and 76 for receiving the transversely disposed infrared lamps 72 are more closely spaced in the entrance portion of the heating chamber 30 than in the remaining portion thereof. Such an arrangement provides for initially quickly heating up to a desired temperature the thick film circuits 103 (Fig. 2) placed on the conveyor belt 20 at the entrance end of the heating chamber 30.

As indicated in Fig. 2, the heating chamber 30 can be made as long as desired. Groups of successive infrared lamps 72 inserted in the upper and lower holes 75 and 76 thereof (Fig. 6) are then coupled together to form as many longitudinal zones as desired having separate control circuits to provide a desired thermal gradient or profile along the path of the conveyor belt 20. The near infrared radiation from lamps 72 is directly dependent on the voltage amplitude supplied to the lamp filaments. Temperature probes 105 each include a thermocouple with one junction lying in chamber 30 between top sheet 38 and lamps 72 (Fig. 4). As shown in Fig. 21, each temperature probe 105 is coupled to a voltage control circuit 109 which in turn supplies voltage to a group of lamp filaments 193. The amplitude of the voltage supplied by circuits 109 is controlled responsive to probe 105 so as to maintain a preset, preferably adjustable, operating temperature, typically in the range 850° to 900°C, in chamber 30. As the temperature sensed by probe 105 deviates from the preset value, control circuit 109 changes the voltage applied to lamp filaments 193 so as to return the sensed temperature to the preset value.

The edge support quartz tubes 64 within the heating chamber 30 for the endless conveyor belt 20 enclose infrared heater coils 69 (Fig. 4) to provide for heating the longitudinal side edge portions of the conveyor belt 20 to thereby provide a constant transverse temperature profile. Since the support quartz tubes 64 tend to wear with use, they are freely held in the semi-circular grooves 39 on the end walls of the heating chamber 30, such that they need be simply rotated after a period of time to present a new wear surface for the conveyor belt 20.

It should now be clearly understood, as seen in Figs. 4 and 6, that the main purpose of the top and bottom sheet metal covers 45 and 48 provided for the heating chamber 30 is to structurally hold together the sheets of insulation of which its rectangular enclosure is constructed. Furthermore, these top and bottom sheet metal covers 45 and 48 hold the insulating walls of the heating chamber 30 together as an assembled unit such that it need be only supported at its four corners by support lugs 82 attached by bolts 83 to the top longitudinal side members 15a of the lower framework 15, thereby having a minimum contact with the supporting structure while being able to be surrounded by cooling air being drawn past it by the fan 37.

It should now be further understood that the insulating sheets 38, 40 and 43 of which the heating chamber 30 is constructed are made sufficiently thick to keep down the heat transfer from the interior of the heating chamber 30 so that the top and bottom sheet metal covers 45 and 48 are held at a reasonable temperature.

Reference will next be made to Figs. 3 and 7 which show the baffle unit 84 provided at the entrance end of the heating chamber 30. The baffle unit provided at the exit end of the heating chamber is constructed the same as the one for the entrance end. Each baffle unit 84 includes a sheet metal tunnel housing 86 which enlcoses a vertically adjustable baffle assembly 87. A sheet metal passageway 98 having double sheet metal walls enclosing sheets III of insulation provides for connecting the end of the sheet metal tunnel housing 86 to the end of the heating chamber 30. The adjustable baffle assembly 87 comprises a sheet metal horizontally disposed inner wall 89 having its sides bent upwardly to slide vertically relative to the inner side walls of the tunnel housing 86. The movable inner wall 89 has a plurality of spaced transversely disposed baffle walls 90 welded to depend from the bottom thereof and a series of holes 91 disposed transversely thereon at a point near the outer baffle walls 90. Two insulating sheet members 93 and 94 are supported on the top surface of the movable inner wall 89 and spaced to provide a slit or channel opening 95 above the series of holes 91 thereon.

The movable inner wall 89 is supported at each corner thereof by tie rods 96 which extend up through the top wall of the tunnel housing 86 and are held by nuts 97. It should thus be evident that by loosening or tightening the nuts 97 on each of the corner tie rods 96, the movable inner wall 89 can be raised or lowered so that the lower ends of the depending baffle walls 90 can be adjusted relative to the top surface of the conveyor belt 20. The space between the inner top wall of tunnel housing 86 and the top of the insulated sheet members 93 and 94 forms a plenum chamber 99 for baffle gas. Such a construction permits the depending baffle walls 90 to be vertically positioned so that their bottom ends just clear thick film circuits 103 (Fig. 3) being carried on the conveyor belt 20 for processing in the heating chamber 30.

The hollow interior of the sheet metal base 100 for baffle housing 86 is covered with spaced sheet members 101 and 102 of insulation. Disposed in the space between sheet members 101 and 102 is a small sheet metal plenum chamber 104 having a connector 92 in the bottom wall thereof which is connected to a tube 106 supplied with a baffle gas. Located above a slot 114 in the plenum chamber 104 is a member 107 which has a series of holes 108 in the top thereof for introducing the baffle gas. It should be noted that the lower series of holes 108 in member 107 is offset a short distance along the path of the conveyor belt 20 from the upper series of holes 91 on the movable inner wall 89. The three belt support quartz tubes 64 have their terminal ends reely resting on the top of the plenum chamber 104 (Fig. 3) and the terminal wires (not shown) of the infrared heater coils 69 within the edge quartz tubes 64 pass out through holes 108 in member 107.

Mounted about a sheet metal outlet port 116 on the outer end of the metal housing 86 is an exhaust duct 110.

A slot 117 in the top of the output port 116 opens to the bottom of the exhaust duct 110. The exhaust duct 110 is a vertically extending rectangular chimney provided with a manually adjustable damper 112. The exhaust duct 110 creates a draft to the outside atmosphere for the hot mixture of cover gas, baffle gas, and any outside air which may enter the tunnel housing 86. The exhaust duct 110 thus helps to prevent outside air from passing into and contaminating the atmosphere within the heating chamber 30. The damper 112 can be manually adjusted to control the amount of hot gas permitted to be withdrawn in this manner.

It should now be clear that the cover gas and baffle gas are provided as indicated by flow meters 113 (Fig. 2) on the end wall of the pedestal 12. The cover gas, which may be nitrogen or oxygen, for example, is fed under a slight pressure by way of tubes 179 to connectors 180 and 181 on a respective plenum chamber 46 and 49 on the top and bottom of heating chamber 30, as illustrated in Figs. 2, 3, and 4. The cover gas is thus forced to slowly and evenly filter through all portions of the sheets 43 and 38 of porous insulation which form the top and bottom walls of the heating chamber 30. In other words, the insulation sheets 43 and 38 must have sufficient porosity to pass the pressurized cover gas so that it disburses throughout the large area of the internal upper and lower walls of the heating chamber 30 at a low velocity, i.e., so that an even, slow, moving blanket of cover gas is introduced into the heating chamber 30 without creating any substantial gas movement therein.

As illustrated in Figs. 2 and 3, the cover gas is also fed as a baffle gas by way of tubes 106 and connectors 88 and 92 to the respective plenum chamber 99 formed on the upper portion of the tunnel housing 86 and the plenum chamber 104 provided at the bottom of the tunnel housing 86 just below the conveyor belt 20. The baffle gas is thus introduced by way of the series of holes 91 into the area above the conveyor belt 20 and by way of the longitudinally offset series of holes 108 into the area below the conveyor belt 20. Such an introduction of the baffle gas creates a turbulance which effectively purges the open mesh of the conveyor belt 20 of any air of water vapor which may be trapped therein as a result of moving in from the outside atmosphere. It should now be understood that the baffle walls 90 serve to confine the turbulent baffle gas so created to the outer end portion of the tunnel housing 86 and also serve to prevent this turbulance from being felt with in or carried into the heating chamber 30.

It should now be especially noted there are no metal construction parts within the heating chamber 30 of the infrared furnace 10 of the present invention, other than the conveyor belt 20 which is continually moving therethrough. Thus, the radiation from the infrared lamp 72, which does not directly strike the thick film circuit 103 being carried by the conveyor belt 20, upon hitting the white smooth surfaces of the sheets of insulation material forming the internal walls of heating chamber 30, in part reflects back onto the thick film circuits 103. Thus, the smooth white walls of the sheets of insulation effectively serve to increase the direct absorption of the near infrared rays by thick film circuits 103.

By controlling the operation of the upper and lower series of infrared lamps 72, the temperature of the heating chamber 30 can be incrementally stepped from the ambient room temperature to any desired set operating temperature up to 1000°C in a matter of minutes. Moreover, the temperature in each of the several longitudinal zones can be rapidly changed without overshoot from one temperature level to another as required for processing workpieces such as integrated circuits chips, thick film circuit boards, and solar cells. It should be understood that the fast, even response of the infrared furnace 10 to its temperature controls is aided by the fact that no cooling is provided for metal walls or reflectors within the heating chamber, such as conventionally provided in infrared furnaces. Such metal parts heat up by absorbing the infrared radiation and despite the cooling create hot spots within the heating chamber which foul up the temperature profile.

It should now be clear that the sheets 38 and 40 of insulation which form the inner walls of the heating chamber 30 serve to contain the heat supplied by the infrared lamps 72, to introduce cover gas at a low static pressure into the heating chamber 30, to reflect the radiation from the infrared lamps 72 back to the thick film circuits 103 being processed, and to radiate far infrared radiation from their walls to the thick film circuits 103.

The controlled atmosphere capability provided by the introduction of a cover gas such as nitrogen for example, into the heating chamber 30 is highly useful in that it keeps out unwanted gases such as the oxygen and thereby permits high temperature operation without, for example, the oxidation problems associated with metal alloys.

The described furnace is referred to herein as an IR furnace because it has a heating zone in which thick film circuits are exposed to direct near infrared radiation from a source at a temperature substantially higher than the heating zone. Heating chamber 30 forms the heating zone through which thick film circuits 103 are transported on conveyor belt 20. Lamps 72 function as a source of near infrared radiation with energy concentration a wavelength band of approximately 0.7 to 2.5μm. Lamps 72, being arranged in side-by-side relationship along the entire length of conveyor belt 20 within chamber 30 above and below the conveyor belt path, directly radiate near infrared energy into the thick film circuits such as 103, thereby transferring heat thereto. In addition, lamps 72 radiate near infrared energy to the walls of chamber 30, i.e., sheets 38 and 40 to transfer heat thereto. The walls of heating chamber 30 in turn, radiate far infrared energy concentrated in a higher wavelength band, i.e., approximately 2.5 to 20μm to the thick film circuits. Thus, there are two components of heat transfer to the thick film circuits, direct radiation from the infrared source and indirect radiation via the walls of heating chamber 30. The indirect heat transfer component to each thick film circuit is represented by the expression

$$q_1 = \varepsilon A\sigma[T_B^4 - T_W^4] \qquad (1)$$

where $q_1$ is the heat transfer to the work piece, i.e., the thick film circuit, $\varepsilon$ is the emissivity, A is the heat transfer surface area, $\sigma$ is the Stefan-Boltzmann constant, $T_B$ is the bulk temperature in degrees Kelvin of the walls of chamber 30, which is the operating temperature of the furnace when in operation, and $T_W$ is the temperature in degees Kelvin of the work piece. The direct heat transfer component to each thick film circuit is represented by the expression

$$q_2 = \varepsilon A\sigma[T_F^4 - T_W^4], \qquad (2)$$

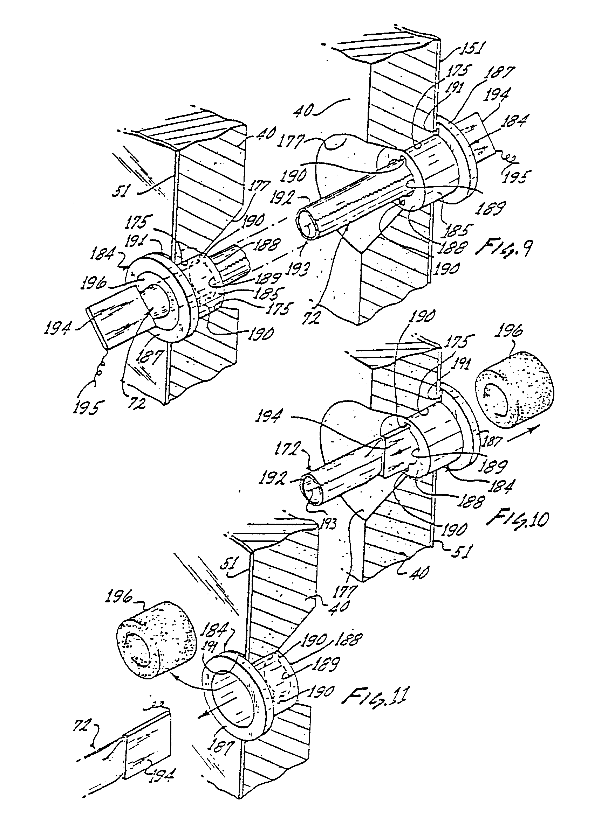

where $q_2$ is the direct heat transfer to the workpiece, $T_F$ is the filament temperature of the source in degrees Kelven and $\varepsilon$, A, $\sigma$, and $T_W$ are as defined above. The total heat transfer to the workpiece is represented by the expression

$$Q = q_1 = q_2, \qquad (3)$$

where Q is the total heat transfer. The thermal mass of the radiating source, i.e., the lamp filaments, is substantially smaller than the thermal mass of material heated thereby, namely the walls of chamber 30, conveyor 20, and the thick film circuits. As a result, the bulk temperature, $T_B$, in the heating zone, i.e., the temperature of the surfaces within the heating chamber 30 including its walls, remains much lower than the filament temperature, $T_F$, of the near infrared radiation source. Typically, $T_F$, is of the order of 1400° to 2000°K and $T_B$ is of the order of 1120° to 1170°K. When a thick film circuit first enters the heating zone, its temperature is substantially lower than both the bulk temperature and the filament temperature, so that substantial heat transfer takes place by both direct and indirect radiation. As the temperature of the work piece rises and approaches the bulk temperature, the heat transfer by indirect radiation drops off asymptotically, but the heat transfer by direct radiation continues at a high rate. This leads to a substantially faster firing interval, i.e., processing time than in a conventional furnace where the work pieces are only heated by indirect radiation. Fig. 15 depicts for a conventional furnace and an IR furnace a typical temperature of a thick film circuit as a function of time and the length of the firing interval required to process the workpiece. As illustrated, the processing time can be reduced by as much as threefold or more in an infrared IR furnace, depending upon the circumstance. As a result, the length of the conveyor belt and thus the furnace as a whole, can be substantially reduced.

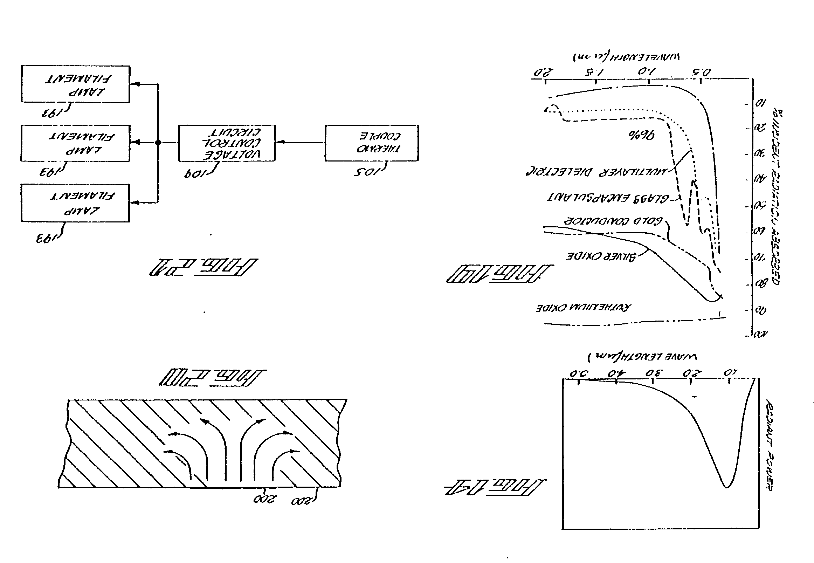

Similarly, the use of direct near infrared radiation from a source at a substantially higher temperature than the bulk temperature, markedly accelerates the heating of the walls of the heating chamber. Less insulation is also required in an IR furnace because of the large direct radiation component and the high filament temperature of the near infrared source. Consequently, an IR furnace can have a smaller thermal mass than a conventional furnace, without excessive heat loss. These factors permit the bulk temperature of the IR furnace to be changed more rapidly than a conventional furnace. Fig. 16 depicts for a conventional furnace and an IR furnace rapidly rises to its operating temperature, while the conventional furnace rises asymptotically to its operating temperature. Fig. 17 depicts for a conventional furnace and an IR furnace, the profile of the change time, showing how an IR furnace changes rapidly from an initial temperature to a new temperature, while a conventional furnace approaches the new temperature asymptotically. Fig. 18 depicts for an IR furnace and a conventional furnace, typical relative power usage, showing the power usage as a function of the operating hours of the furnace per day. Since the conventional furnace is continuously heated 24 hours a day, regardless of number of operating hours, its power usage is constant, while the power usage of an IR furnace increases linearly as a function of the operating hours per day because the IR furnace is turned off when not it use. It should be noted that even when an IR furnace is operated 24 hours a day, it uses substantially less power than a conventional furnace because of the power transfer efficiency of the direct radiation component and the smaller permissible thermal mass.

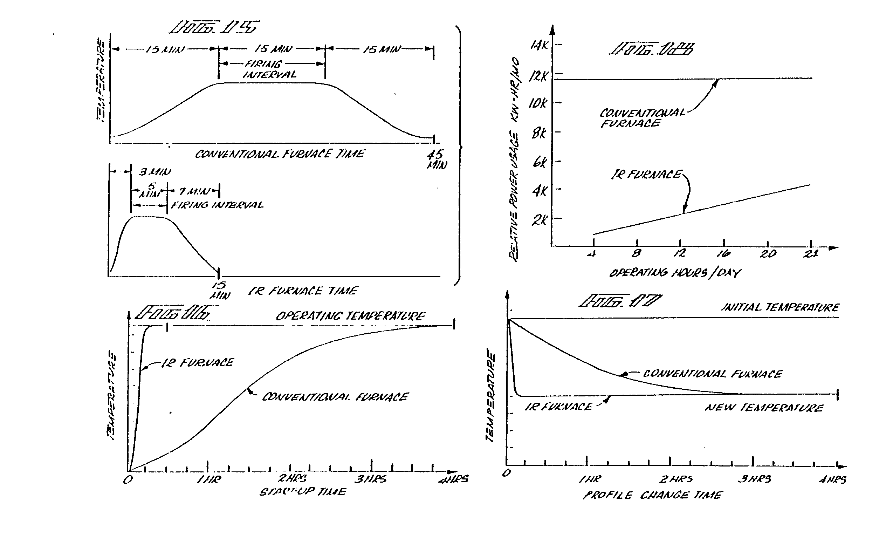

Typically, a thick film circuit comprises a relatively thick, e.g., 0.635μm (25 mil), insulative substrate, e.g., 96% Alumina, on which thin, e.g., 10 to 12.5μm layers of material are deposited to form resistors, capacitors, conductors, and the like in well-known manner. As a result, the substrate has a substantially larger thermal mass than the layers. Typically, these materials, which include Ruthenium oxide and glass frits, silver, gold, glass, and dielectric are applied to the substrate in the form of a paste. After the layers are applied, the thick film circuits are fired to cure and/or dry the layers and thereby fix them on the substrate. It has been discovered that some of the materials from which the layers are formed, notably Ruthenium oxide and glas frits, and, to a lesser extent, silver and gold, absorb a substantially greater percentage of incident near infrared radiation than the substrate. Fig. 19 depicts the per cent of incident radiation absorbed during firing for the different materials of a typical thick film circuit as a function of wavelength between 0.5 and 2.0μm. As depicted, Ruthenium oxide absorbs between 90% and 100% of the radiation, while a 96% Alumina substrate absorbs less than 10% thereof. Fig. 20 depicts a portion of a thick film circuit comprising a 96% Alumina substrate 200 coated with a Ruthenium oxide layer 210. During firing in the described IR furnace, both substrate 200 and layer 210 are heated by indirect radiation from the walls of heating chamber 30 and are heated by direct radiation from lamp 72 as described above. The direct radiation selectively heats layer 210 without appreciably heating substrate 200 because of the difference in absorptivity. The temperature of layer 210 however, is prevented from rising appreciably above the temperature of substrate 200 because the large mass of substrate 200 functions as a heat sink to withdraw heat from layer 210, as depicted by the arrows in Fig. 20. Thus, although layer 210 is rapidly and thoroughly heated by the direct near infrared near infrared radiation from the filaments of lamps 72, which are at a temperature substantially higher than the bulk temperature, its temperature is clamped essentially to the temperature of substrate 200, which essentially rises no higher than the bulk temperature of the IR furnace. As a result of the thorough heating of layer 210, it is completely cured and/or dried without damage to the material. In the case of a Ruthenium oxide resistor, the thorough curing has been found to provide lower resistance values and smaller tolerances, both very desirable characteristics in a thick film circuit.

**Claims**

1. An infrared furnace (10) for firing thick film circuits comprising a heating chamber (30) having insulated walls (45, 48, 51) defining an elongated straight tunnel disposed on a longitudinal axis between an entrance and an exit, a product conveyor (20) movable through the tunnel along the longitudinal axis between the entrance and the exit, a plurality of elongated tubular infrared lamps (72) disposed in the tunnel in direct communication with the conveyor (20), and means for applying electrical energy to the lamps (72) to energize them, characterized in that temperature probes (105) are provided for sensing the temperature in at least one zone of the tunnel and means (109) responsive to temperature sensing probes (105) are provided for controlling the voltage of the electrical energy applied to the infrared lamps (72) to maintain the desired operating temperature in the zone constant, and maintain the quantity of heat that needs to be transferred to the thick film circuits which in turn depends upon the transport speed of the thick film circuits.

2. The furnace of claim 1, characterized in that the walls defining the tunnel comprise approximately horizontal top (45) and bottom (48) walls and approximately vertical side walls (51) together forming a rectangular cross section and the infrared lamps (72) are parallel to the top (45) and bottom (48) walls and perpendicular to the side walls (51).

3. The furnace of claim 1 or 2, characterized in that the infrared lamps (72) are closer together near the entrance than in the interior of the tunnel.

4. The furnace of claim 1, 2 or 3, characterized in that there are separate temperature probes (105) in a plurality of zones of the tunnel and the controlling means (109) controls the voltage of the electrical energy applied to the infrared lamps (72) in the zones to maintain the temperature in such zones constant.

5. The furnace of claim 4, characterized in that the controlling means (109) maintains a lower temperature in the zone adjacent to the entrance than zones more remote from the entrance.

6. The furnace of one of claims 1 through 5, characterized in that the ends of the infrared lamps (72) are supported by the side walls.

7. The furnace of one of claims 1 through 6, characterized in that the ends of the infrared lamps (72) pass through the side walls (51) to the exterior of the housing, the furnace additionally comprising an outer enclosure (17, 19) surrounding the top (45), bottom (48), and side (51) walls in spaced relationship from the side walls (51), means for applying electrical energy to the infrared lamps (72) to energize them, and means (37) for blowing gas between the enclosure (17, 19) and the side walls (51) to cool the ends of the infrared lamps (72).

8. The furnace of one of claims 2 through 7, characterized in that the walls each comprise a porous insulative inner panel (43, 38, 40) and a non-porous outer panel (45, 48, 51), at least one of the outer panels (45, 48) being spaced from its associated inner panel (38, 43) to form a plenum chamber (46, 49) therebetween, the furnace additionally comprising means (179, 180, 181) for supplying gas under pressure to the plenum chamber (46, 49) to induce flow through the inner panel (38, 43) to the tunnel.

9. The furnace of claim 8, characterized in that the outer panels (45, 48, 51) are metallic.

10. The furnace of one of claims 1 through 9, characterized in that it comprises additionally one or more tubes (64) extending through the tunnel parallel to its longitudinal axis directly under the conveyor (20) to support the conveyor (20).

11. The furnace of one of claims 1 through 10, characterized in that it comprises additionally a plurality of parallel spaced apart tubes (64) extending through the tunnel parallel to its longitudinal axis directly under the conveyor (20) to support the conveyor (20).

12. The furnace of claim 11, characterized in that it comprise a heater (69) disposed in at least one of the tubes (64).

13. The furnace of claim 11, characterized in that two of the tubes (64) lie near the respective side walls (51) of the housing, the furnace additionally comprising a heater (69) disposed in the two tubes (64) to compensate for heat loss through the side walls (51) of the housing.

14. The furnace of one of claims 1 through 13, characterized in that the infrared lamps (72) comprise tungsten filaments (193) enclosed in a sealed quartz envelope (192) with an inert gas.

15. The furnace of one of claims 1 through 14, characterized in that the temperature of the infrared lamps (72) is of the order of 1400°K to 2000°K.

16. The furnace of one of claims 1 through 15, characterized in that the temperature in the interior of the tunnel is of the order of 1120°K to 1170°K.

17. The furnace of one of claims 1 through 15, characterized in that the plurality of infrared lamps (72) comprises a first group of infrared lamps (72) nearest to the entrance of the tunnel (30) and one or more other groups of infrared lamps (72) between the first group and the exit from the tunnel (30), the temperature probes (105) are comprising a first temperature probe in the vicinity of the first group of infrared lamps (72) and one or more other temperature probes (105) in the vicinity of the respective one or more other groups of infrared lamps (72), and the means for controlling the voltage maintains the temperature in the vicinity of the first group of infrared lamps (72) at a constant value between 1,120°K and 1,170°K and maintains the temperature in the vicinity of the one or more other groups of infrared lamps (72) at a constant value between about 1,120°K and 1,170°K.

**Patentansprüche**

1. Infrarotofen (10) zum Einbrennen von Dickschichtschaltkreisen mit einer Heizkammer (30) mit Isolierwänden (45, 48, 51), die einen länglichen, geraden Tunnel begrenzen, der auf einer Längsachse zwischen einem Einlaß und einem Auslaß angeordnet ist, einem durch den Tunnel längs der Längsachse zwischen dem Einlaß und dem Auslaß bewegbaren Produktförderer (20), einer Vielzahl von länglichen, rohrförmigen Infrarotlampen (72), die in dem Tunnel in direkter Verbindung mit dem Förderer (20) angeordnet sind, und Mitteln zum Zuführen elektrischer Energie zu den Lampen (72) zu deren Erregung, dadurch gekennzeichnet, daß

Temperaturfühler (105) zum Erfassen der Temperatur in wenigstens einem Bereich des Tunnels und Mittel (109) vorgesehen sind, die auf die Temperaturfühler (105) ansprechen, um die Spannung der an die Infrarotlampen (72) angelegten, elektrischen Energie zu steuern, damit die erwünschte Betriebstemperatur in dem Bereich konstant gehalten wird, und um die Wärmemenge aufrecht zu erhalten, die auf die Dickschichtschaltkreise übertragen werden muß, welch wiederum von der Transportgeschwindigkeit der Dickschichtschaltkreise abhängt.

2. Ofen nach Anspruch 1, dadurch gekennzeichnet, daß die den Tunnel begrenzenden Wände eine in etwa horizontale obere Wand (45) und Bodenwand (48) und in etwa vertikale Seitenwände (51) umfassen, die zusammen einen rechteckförmigen Querschnitt bilden, und daß die Infrarotlampen (72) parallel zu der oberen Wand (45) und der Bodenwand (48) und senkrecht zu den Seitenwänden (51) sind.

3. Ofen nach Anspruch 1 oder 2, dadurch gekennzeichnet, daß die Infrarotlampen (72) nahe dem Einlaß näher beieinander sind, als im Inneren des Tunnels.

4. Ofen nach Anspruch 1, 2 oder 3, dadurch gekennzeichnet, daß sich in einer Vielzahl von Bereichen des Tunnels getrennte Temperaturfühler (105) befinden und daß die Steuerungsmittel (109) die Spannung für die zu den Infrarotlampen (72) in den Bereichen geführte elekrische Energie steuert, um die Temperatur in solchen Bereichen konstant zu halten.

5. Ofen nach Anspruch 4, dadurch gekennzeichnet, daß die Steuerungsmittel (109) eine niedere Temperatur in dem dem Einlaß benachbarten Bereich als in den von dem Einlaß weiter entfernten Bereichen aufrecht erhält.

6. Ofen nach einem der Ansprüche 1 bis 5, dadurch gekennzeichnet, daß die Enden der Infrarotlampen (72) von den Seitenwänden abgestützt sind.

7. Ofen nach einem der Ansprüche 1 bis 6, dadurch gekennzeichnet, daß sich die Enden der Infrarotlampen (72) durch die Seitenwände (51) nach außerhalb des Gehäuses erstrecken, daß der Ofen zusätzlich umfaßt eine die obere Wand (45), den Boden (48) und die Seitenwände (51) in Abstandsbeziehung zu den Seitenwänden (51) umgebende, äußere Umhüllung (17, 19), eine Einrichtung zum Anwenden elektrischer Energie auf die Infrarotlampen (72) zu deren Erregung, und Mittel (37) zum Blasen von Gas zwischen die Umhüllung (17, 19) und die Seitenwände (51), um die Enden der Infrarotlampen (72) zu kühlen.

8. Ofen nach einem der Ansprüche 2 bis 7, dadurch gekennzeichnet, daß jede der Wände eine poröse, isolierende, innere Platte (43, 38, 40) und eine nichtporöse, äußere Platte (45, 48, 51) aufweist, wobei zumindest eine der äußeren Platten (45, 48) von ihrer zugeordneten, inneren Platte (38, 43) beabstandet ist, um dazwischen eine Kammer (46, 49) zu bilden, und daß der Ofen zusätzlich Mittel (179, 180, 181) umfaßt, um Gas unter Druck der Kammer (46, 49) zuzuführen, um eine strömung durch die innere Wand (38, 43) in dem Tunnel hervorzurufen.

9. Ofen nach Anspruch 8, dadurch gekennzeichnet, daß die äußeren Platten (45, 48, 51) metallisch sind.

10. Ofen nach einem der Ansprüche 1 bis 9, dadurch gekennzeichnet, daß er zusätzlich eine oder mehrere Röhren (64) umfaßt, die sich durch den Tunnel parallel zu seiner Längsachse unmittelbar unter dem Förderer (20) erstrecken, um den Förderer (20) zu stützen.

11. Ofen nach einem der Ansprüche 1 bis 10, dadurch gekennzeichnet, daß er zusätzlich eine Vielzahl von parallel beabstandeten Röhren (64) umfaßt, die sich durch den Tunnel parallel zu seiner Längsachse unmittelbar unter dem Förderer (20) erstrecken, um den Förderer (20) zu stützen.

12. Ofen nach Anspruch 11, dadurch gekennzeichnet, daß er eine Heizeinrichtung (69) umfaßt, die in zumindest einer der Röhren (64) angeordnet ist.

13. Ofen nach Anspruch 11, dadurch gekennzeichnet, daß zwei der Röhren (64) nahe bei den entsprechenden Seitenwänden (51) des Gehäuses liegen und der Ofen zusätzlich eine Heizeinrichtung (69) aufweist, die in den zwei Röhren (64) angeordnet ist, um Wärmeverluste durch die Seitenwände (51) des Gehäuses auszugleichen.

14. Ofen nach einem der Ansprüche 1 bis 13, dadurch gekennzeichnet, daß die Infrarotlampen (72) Wolframheizfäden (193) umfassen, die in einer abgedichteten Quarzumhüllung (192) mit einem Inertgas eingeschlossen sind.

15. Ofen nach einem der Ansprüche 1 bis 14, dadurch gekennzeichnet, daß die Temperatur der Infrarotlampen (72) in der Größenordnung von 1400°K bis 2000°K beträgt.

16. Ofen nach einem der Ansprüche 1 bis 15, dadurch gekennzeichnet, daß die Temperatur im Inneren des Tunnels in der Größenordnung von 1120°K bis 1170°K beträgt.

17. Ofen nach einem der Ansprüche 1 bis 15, dadurch gekennzeichnet, daß die Vielzahl von Infrarotlampen (72) eine erste, dem Einlaß des Tunnels (30) am nächsten und eine oder mehrere andere Gruppen von Infrarotlampen (72) zwischen der ersten Gruppe und dem Auslaß des Tunnels (30) aufweist, daß die Temperaturfühler (105) einen ersten Temperaturfühler nahe bei der ersten Gruppe von Infrarotlampen (72) und einen oder mehrere andere Temperaturfühler (105) nahe bei der jeweils einen oder mehreren anderen Gruppe von Infrarotlampen (72) umfassen, und daß die Mittel zur Steuerung der Spannung die Temperatur nahe der ersten Gruppe von Infrarotlampen (72) auf einen konstanten Wert zwischen 1120°K und 1170°K und die Temperatur in der Nähe der einen oder mehreren anderen Gruppen von Infrarotlampen (72) auf einem konstanten Wert zwischen ungefähr 1120°K und 1170°K aufrecht erhält.

**Revendications**

1. Four à infrarouge (10) pour la cuisson de circuits à couche épaisse, comprenant une chambre de chauffage (30) comportant des parois isolées (45, 48, 41) délimitant un long tunnel droit disposé suivant un axe longitudinal entre une entrée et une sortie, un transporteur de produits (20) déplaçable à travers le tunnel suivant l'axe longitudinal existant entre l'entrée et la sortie, une série de longues lampes tubulaires à infrarouge (72) disposées dans le tunnel en communication directe avec le transporteur (20), et des moyens pour alimenter une énergie électrique aux lampes (72) pour les faire fonctionner, caractérisé en ce que des sondes de température (105) sont prévues pour déceler la température dans au moins une zone du tunnel, et des moyens (109) sensibles aux sondes de détection de température (105) sont prévus pour régler la tension de l'énergie électrique appliquée aux lampes à infrarouge (72) en vue de maintenir constante la température de fonctionnement désirée dans la zone, et d'entretenir la quantité de chaleur que doit être transférée aux circuits à couche épaisse, ce qui, à son tour, dépend de la vitesse de transport des circuits à couche épaisse.

2. Four suivant la revendication 1, caractérisé en ce que les parois délimitant le tunnel comprennent des parois supérieure (45) et inférieure (48) sensiblement horizontales, et des parois latérales (51) sensiblement verticales, formant ensemble une section transversale rectangulaire, les lampes à infrarouge (72) étant parallèles aux parois supérieure (45, et inférieure (48) et perpendiculaires aux parois latérales (51).

3. Four suivant la revendication 1 ou 2, caractérisé en ce que les lampes à infrarouge (72) sont plus proches les unes des autres au voisinage de l'entrée qu'à l'intérieur du tunnel.

4. Four suivant l'une quelconque des revendications 1 à 3, caractérisé en ce qu'on prévoit des sondes de température distinctes (105) dans une série de zones du tunnel, et en ce que les moyens de contrôle (109) règlent la tension de l'énergie électrique appliquée aux lampes à infrarouge (72) dans les zones susdites afin de maintenir constante la température dans celles-ci.

5. Four suivant la revendication 4, caractérisé en ce que les moyens de contrôle (109) entretiennent une température plus basse dans la zone voision de l'entrée que dans les zones plus éloignées de celle-ci.

6. Four suivant l'une quelconque des revendications 1 à 5, caractérise en ce que les extrémités des lampes à infrarouge (72) sont supportées par les parois latérales.

7. Four suivant l'une quelconque des revendications 1 à 6, caractérisé en ce que les extrémités des lampes à infrarouge (72) traversent les parois latérales (51) vers l'extérieur du logement, le four comprenant en outre une enceinte externe (17, 19) entourant les parois supérieure (45), inférieure (48) et latérales (51), et ce en relation espacée par rapport aux parois latérales (51), des moyens pour alimenter une énergie électrique zux lampes à infrarouge (72) pour les faire fonctionner, et des moyens (37) pour souffler un gaz entre l'enceinte (17, 19) et les parois latérales (51) en vue de refroidir les extrémités des lampes à infrarouge (72).

8. Four suivant l'une quelconque des revendications 2 à 7, caractérisé en ce que les parois comprennent chacune un panneau interne isolant poreux (43, 38, 40) et un panneau externe non poreux (45, 48, 51), au moins l'un des panneaux externes (45, 48) étant espacé de son panneau interne associé (38, 43) pour former une chambre de pression (46, 49) entre eux, le four comprenant en outre des moyens (179, 180, 181) pour alimenter un gaz sous pression à la chambre de pression (46, 49) afin de provoquer une circulation à travers le panneau interne (38, 43) vers le tunnel.

9. Four suivant la revendication 8, caractérisé en ce que les panneaux externes (45, 48, 51) sont métalliques.

10. Four suivant l'une quelconque des revendications 1 à 9, caractérisé en ce qu'il comprend en outre un ou plusieurs tubes (64) s'étendant à travers le tunnel, parallelement à son axe longitudinal, directement sous le transporteur (20), en vue de supporter ce transporteur (20).

11. Four suivant l'une quelconque des revendications 1 à 10, caractérisé en ce qu'il comprend en outre une série de tubes parallèles espacés (64) s'étendant à travers le tunnel, parallèlement à son axe longitudinal, directement sous le transporteur (20) pour soutenir celui-ci.

12. Four suivant la revendication 11, caractérisé en ce qu'il comprend un dispositif chauffant (69) disposé dans au moins un des tubes (64).

13. Four suivant la revendication 11, caractérisé en ce que deux des tubes (64) se situent près des parois latérales correspondantes (51) de l'enceinte, ce four comprenant en outre un dispositif chauffant (69) disposé dans les deux tubes (64) pour compenser la perte de chaleur à travers les parois latérales (51) de l'enceinte.

14. Four suivant l'une quelconque des revendications 1 à 13, caractérisé en ce que les lampes à infrarouge (72) comportent des filaments en tungstène (193) renfermés dans une enveloppe scellée en quartz (192) comportant un gaz inerte.

15. Four suivant l'une quelconque des revendications 1 à 14, caractérisé en ce que la température des lampes à infrarouge (72) est de l'ordre de 1400 à 2000°K.

16. Four suivant l'une quelconque des revendications 1 à 15, caractérisé en ce que la température régnant à l'intérieur du tunnel est de l'ordre de 1120°K à 1170°K.

17. Four suivant l'une quelconque des revendications 1 à 15, caractérisé en ce que la série des lampes à infrarouge (72) comprend un premier groupe de lampes à infrarouge (72) situées très proches de l'entrée du tunnel (30) et un ou plusieures autres groupes de lampes à infrarouge (72) situées entre le premier groupe et la sortie du tunnel (30), les sondes de température (105) comportent une première sonde de température au voisinage du premier groupe de lampes à infrarouge (72) et une ou plusieurs autres sondes de température (105) au voisinage d'un ou de plusieurs des autres groupes de lampes à infrarouge (72), et les moyens de contrôle de la tension entretiennent la température au voisinage du premier groupe de lampes à infrarouge (72) à une valeur constante comprise entre 1120°K et 1170°K et entretiennent la température au voisinage d'un ou plusieurs des autres groupes de lampes à infrarouge (72) à une valeur constante comprise entre environ 1120°K et 1170°K.

*Fig. 1*

*Fig. 2*

FIG. 3

Fig. 4

Fig. 8

FIG.5

FIG.13

FIG.12

FIG.6

0 061 158

FIG.7

*Fig.9*

*Fig.10*

*Fig.11*

Fig.14

RADIANT POWER

WAVE LENGTH (μm)

1.0 2.0 3.0 4.0 5.0

Fig.20

200 200

Fig.19

% INCIDENT RADIATION ABSORBED

RUTHENIUM OXIDE

SILVER OXIDE

GOLD CONDUCTOR

GLASS ENCAPSULANT

MULTILAYER DIELECTRIC

96%

0.5 1.0 1.5 2.0

WAVELENGTH (μm)

Fig.21

THERMO COUPLE
105

VOLTAGE CONTROL CIRCUIT
109

LAMP FILAMENT
193

LAMP FILAMENT
193

LAMP FILAMENT
193

FIG. 11b

RELATIVE POWER USAGE KW-HR/MO

CONVENTIONAL FURNACE

IR FURNACE

OPERATING HOURS/DAY

FIG. 11d

INITIAL TEMPERATURE

CONVENTIONAL FURNACE

NEW TEMPERATURE

IR FURNACE

TEMPERATURE

PROFILE CHANGE TIME

FIG. 11c

CONVENTIONAL FURNACE TIME

FIRING INTERVAL

IR FURNACE TIME

FIRING INTERVAL

TEMPERATURE

FIG. 11a

OPERATING TEMPERATURE

CONVENTIONAL FURNACE

IR FURNACE

TEMPERATURE

START-UP TIME